(19) **Europäisches Patentamt / European Patent Office / Office européen des brevets**

(11) **EP 4 686 105 A1**

(12) **EUROPEAN PATENT APPLICATION**
published in accordance with Art. 153(4) EPC

(43) Date of publication:
**28.01.2026 Bulletin 2026/05**

(21) Application number: **23934339.5**

(22) Date of filing: **23.04.2023**

(51) International Patent Classification (IPC):
**H03M 13/09** (2006.01)　　**H04L 1/00** (2006.01)

(52) Cooperative Patent Classification (CPC):
**H03M 13/09; H04L 1/00**

(86) International application number:
**PCT/CN2023/090080**

(87) International publication number:
**WO 2024/221133 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
　• **WANG, Xianbin**
　**Shenzhen, Guangdong 518129 (CN)**

　• **ZHANG, Huazi**
　**Shenzhen, Guangdong 518129 (CN)**
　• **TONG, Jiajie**
　**Shenzhen, Guangdong 518129 (CN)**
　• **QIN, Kangjian**
　**Shenzhen, Guangdong 518129 (CN)**
　• **LIU, Ke**
　**Shenzhen, Guangdong 518129 (CN)**
　• **WANG, Jun**
　**Shenzhen, Guangdong 518129 (CN)**

(74) Representative: **Grünecker Patent- und**
**Rechtsanwälte**
**PartG mbB**
**Leopoldstraße 4**
**80802 München (DE)**

(54) **DECODING METHOD AND APPARATUS**

(57)　　A decoding method and an apparatus are provided and relate to the field of communication technologies. The method includes: determining a second LLR value different from a first LLR value, for example, determining the second LLR value based on the first LLR value and a first disturbance value; and performing decoding based on the second LLR value to obtain a second decoding result. In this way, error correction performance can be improved.

| Determine a first log-likelihood ratio LLR value | 301 |

| Determine a second LLR value based on the first LLR value and a first disturbance value, where the first LLR value is different from the second LLR value | 302 |

| Perform decoding based on the second LLR value to obtain a second decoding result | 303 |

FIG. 3

Processed by Luminess, 75001 PARIS (FR)

## Description

## TECHNICAL FIELD

This application relates to the field of communication technologies, and in particular, to a decoding method and an apparatus.

## BACKGROUND

In a communication system, channel encoding is usually used to improve data transmission reliability, so as to ensure communication quality. A polar code (polar code) is a first type of code that is theoretically proved to be capable of achieving a Shannon capacity and that has low decoding complexity. The polar code is a linear code, and decoding of the polar code may be performed by using a successive cancellation list (successive cancellation list, SCL) decoding algorithm. When the SCL algorithm is used for decoding, L (where L is a preset path width, and may be an integer greater than or equal to 1) decoding paths are stored. Path metric (path metric, PM) value calculation is performed on the L decoding paths, and a decoding result corresponding to a decoding path with a highest PM value may be selected as a final decoding result. It can be learned that calculation complexity of the SCL algorithm increases with a value of L.

Generally, to improve decoding efficiency, a small value of L is usually used in an actual application process. However, this may limit error correction performance of the polar code.

## SUMMARY

This application provides a decoding method and an apparatus, to improve error correction performance.

According to a first aspect, a decoding method is provided. The decoding method includes: determining a first log-likelihood ratio (likelihood rate, LLR) value; determining a second LLR value based on the first LLR value and a first disturbance value, where the first LLR value is different from the second LLR value; and performing decoding based on the second LLR value to obtain a second decoding result.

In the foregoing embodiment, the second LLR value may be determined based on the first LLR value and the first disturbance value, and decoding is performed based on the second LLR value. In this way, error correction performance can be improved.

There may be one or more first LLR values.

With reference to the first aspect, in a possible implementation, determining the first LLR value includes: obtaining a symbol sequence, where the symbol sequence corresponds to a code bit sequence; demodulating the symbol sequence to obtain a third LLR value; and determining the first LLR value based on the third LLR value.

In the foregoing implementation, the first LLR value may be determined based on the third LLR value obtained by demodulating the symbol sequence corresponding to the code bit sequence. This indicates a specific position at which the first disturbance value may be added.

In this application, the symbol sequence may include one or more symbols.

In this application, the code bit sequence may be determined based on an information bit sequence and a frozen bit sequence. The information bit sequence may include one or more information bits, and the frozen bit sequence may include one or more frozen bits. In a polar code encoding process, a part of bits are for carrying information, and such bits may be referred to as information bits. The other part of bits are fixed bits known to a transmit end and a receive end, and such bits may be referred to as frozen bits.

Optionally, demodulating the symbol sequence to obtain the third LLR value may be understood as obtaining, by performing calculation based on a channel noise variance, a third LLR value corresponding to at least one bit in the code bit sequence corresponding to the symbol sequence. In an example, when binary phase shift keying (binary phase shift keying, BPSK) modulation is used, a third LLR value corresponding to one bit in the code bit sequence may be calculated by using the following formula:

$$\text{LLR(x)} = \ln \frac{p(y|x=0)}{p(y|x=1)} = \frac{2y}{\sigma^2}$$

x represents the bit in the code bit sequence, LLR(x) represents the third LLR value corresponding to the bit, $p(y|x=0)$ represents a probability that a symbol in the symbol sequence is y when a value of x is 0, $p(y|x=1)$ represents a probability that the symbol is y when a value of the bit is 1, and $\sigma^2$ represents a channel noise variance. Another modulation scheme may alternatively be used for demodulation to obtain a corresponding LLR value. A specific modulation scheme is not limited in this application.

With reference to the first aspect, in a possible implementation, the first LLR value includes the third LLR value.

In the foregoing implementation, the first LLR value may include the third LLR value obtained through demodulation based on the symbol sequence. This indicates that the first disturbance value may be added to the third LLR value. In this way, error correction performance can be improved.

With reference to the first aspect, in a possible implementation, determining the first LLR value based on the third LLR value includes: determining an LLR value of an information bit and/or an LLR value of a frozen bit based on the third LLR value, and the first LLR value includes the LLR value of the information bit and/or the LLR value of the frozen bit. Optionally, the information bit is an information bit whose reliability is higher than or equal to preset reliability.

In the foregoing implementation, the first LLR value may include the LLR value of the information bit and/or the LLR value of the frozen bit that are/is determined based on the third LLR value obtained through demodulation based on the symbol sequence. This indicates that the first disturbance value may be added to the LLR value of the information bit and/or the LLR value of the frozen bit. In this way, error correction performance can be improved.

With reference to the first aspect, in a possible implementation, determining the first LLR value based on the third LLR value includes: determining, based on the third LLR value, an LLR value of an intermediate layer node corresponding to an information bit whose reliability is higher than or equal to preset reliability, where the first LLR value includes the LLR value of the intermediate layer node.

In the foregoing implementation, the first LLR value may include the LLR value of the intermediate layer node corresponding to the information bit whose reliability is higher than or equal to preset reliability. This indicates that the first disturbance value may be added to the LLR value of the intermediate layer node. In this way, error correction performance can be improved.

With reference to the first aspect, in a possible implementation, the method further includes: performing decoding based on the third LLR value to obtain a first decoding result; and determining the second LLR value based on the first LLR value and the first disturbance value includes: when the first decoding result is incorrect, determining the second LLR value based on the first LLR value and the first disturbance value.

In the foregoing embodiment, when the first decoding result is incorrect, the second LLR value is determined based on the first LLR value and the first disturbance value. This can avoid a problem of a waste of resources caused by repeated decoding based on the second LLR value that is determined based on the first LLR value and the first disturbance value when the first decoding result is correct.

Performing decoding based on the third LLR value to obtain the first decoding result may include: performing SCL decoding based on the third LLR value to obtain the first decoding result. A specific decoding scheme and a corresponding decoding process are not limited in this application.

With reference to the first aspect, in a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the symbol sequence.

In the foregoing embodiment, when the first disturbance value is the disturbance value generated online, it indicates that a process of generating the first disturbance value is not complex, and the first disturbance value may be quickly generated. When the first disturbance value is the Gaussian distribution noise value or the first disturbance value is determined based on the signal-to-noise ratio and/or the power of the symbol sequence, because an LLR value is related to residual phase noise and additive white noise that are obtained through phase noise estimation, and the residual phase noise and the additive white noise that are obtained through phase noise estimation are generally in Gaussian distribution, when the first disturbance value is the Gaussian distribution noise value or the first disturbance value is determined based on the signal-to-noise ratio and/or the power of the symbol sequence, the second LLR value determined based on the first disturbance value may be more in line with a change in an actual channel condition, so that error correction performance can be improved. When the first disturbance value is the preset disturbance value, processes of generating the first disturbance value in real time are reduced, so that decoding efficiency can be improved.

With reference to the first aspect, in a possible implementation, performing decoding based on the second LLR value to obtain the second decoding result includes: performing SCL decoding based on the second LLR value to obtain the second decoding result. A specific decoding scheme and a corresponding decoding process are not limited in this application.

In the foregoing embodiment, performing SCL decoding based on the second LLR value to obtain the second decoding result can improve error correction performance. For example, error correction performance can still be ensured when L is set to a small value. In addition, when L is a small value, needed storage space is reduced. Therefore, a chip area can be further reduced, and hardware costs can be reduced.

According to a second aspect, a decoding method is provided. The decoding method includes: obtaining a first symbol sequence, where the first symbol sequence corresponds to a code bit sequence; adding a first disturbance value to the first symbol sequence, where the first disturbance value is for generating a second symbol sequence, and the first symbol sequence is different from the second symbol sequence; demodulating the second symbol sequence to obtain a second LLR value; and performing decoding based on the second LLR value to obtain a second decoding result.

In the foregoing embodiment, the first disturbance value is added to the first symbol sequence corresponding to the code bit sequence to obtain the second symbol sequence, so that the second symbol sequence may be demodulated to obtain the second LLR value, and decoding is performed based on the second LLR value. In this way, error correction performance can be improved.

With reference to the second aspect, in a possible implementation, the method further includes: demodulating the first symbol sequence to obtain the first LLR value; and performing decoding based on the first LLR value to obtain a first decoding result; and adding the first disturbance value to the first symbol sequence includes: when the first decoding result is incorrect, adding the first disturbance value to the first symbol sequence.

In the foregoing embodiment, when the first decoding result is incorrect, the first disturbance value is added to the first LLR value. This can avoid a problem of a waste of resources caused by repeated decoding based on the second symbol sequence that is obtained by adding the first disturbance value to the first symbol sequence when the first decoding result is correct.

Optionally, that the terminal device performs decoding based on the first LLR value to obtain the first decoding result may include: The terminal device performs SCL decoding based on the first LLR value to obtain the first decoding result. A specific decoding scheme and a corresponding decoding process are not limited in this application.

With reference to the second aspect, in a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the first symbol sequence.

In the foregoing embodiment, when the first disturbance value is the disturbance value generated online, it indicates that a process of generating the first disturbance value is not complex, and the first disturbance value may be quickly generated. When the first disturbance value is the Gaussian distribution noise value or the first disturbance value is determined based on the signal-to-noise ratio and/or the power of the first symbol sequence, because an LLR value is related to residual phase noise and additive white noise that are obtained through phase noise estimation, and the residual phase noise and the additive white noise that are obtained through phase noise estimation are generally in Gaussian distribution, when the first disturbance value is the Gaussian distribution noise value or the first disturbance value is determined based on the signal-to-noise ratio and/or the power of the first symbol sequence, the second LLR value determined based on the first disturbance value may be more in line with a change in an actual channel condition, so that error correction performance can be improved. When the first disturbance value is the preset disturbance value, processes of generating the first disturbance value in real time are reduced, so that decoding efficiency can be improved.

With reference to the second aspect, in a possible implementation, performing decoding based on the second LLR value to obtain the second decoding result includes: performing SCL decoding based on the second LLR value to obtain the second decoding result. A specific decoding scheme and a corresponding decoding process are not limited in this application.

In the foregoing embodiment, performing SCL decoding based on the second LLR value to obtain the second decoding result can improve error correction performance. For example, error correction performance can still be ensured when L is set to a small value. In addition, when L is a small value, needed storage space is reduced. Therefore, a chip area can be further reduced, and hardware costs can be reduced.

According to a third aspect, a decoding method is provided. The decoding method includes: determining a first LLR value and a second LLR value, where the first LLR value is determined based on a third LLR value, the third LLR value is determined based on a symbol sequence, the symbol sequence corresponds to a code bit sequence, the second LLR value is determined based on the first LLR value and a first disturbance value, and the first LLR value is different from the second LLR value; and performing decoding based on the first LLR value and the second LLR value to obtain a decoding result.

In the foregoing embodiment, decoding is performed based on the first LLR value and the second LLR value to obtain the decoding result, so that parallel decoding based on different LLR values is implemented. This can reduce time for decoding, reduce a decoding delay, and improve decoding efficiency. In addition, performing decoding based on the second LLR value can improve error correction performance.

Optionally, performing decoding based on the first LLR value and the second LLR value to obtain the decoding result includes: performing SCL decoding based on the first LLR value and the second LLR value to obtain the decoding result. A specific decoding scheme and a corresponding decoding process are not limited in this application.

In the foregoing embodiment, performing SCL decoding based on the second LLR value can improve error correction performance. For example, error correction performance can still be ensured when L is set to a small value. In addition, when L is a small value, needed storage space is reduced. Therefore, a chip area can be further reduced, and hardware costs can be reduced.

With reference to the third aspect, in a possible implementation, the first LLR value includes the third LLR value. This indicates that the first disturbance value may be added to the third LLR value obtained through demodulation based on the symbol sequence. In this way, error correction performance can be improved.

With reference to the third aspect, in a possible implementation, that the first LLR value is determined based on the third LLR value includes: The first LLR value includes an LLR value of an information bit and/or an LLR value of a frozen bit, and the LLR value of the information bit and/or the LLR value of the frozen bit are/is determined based on the third LLR value. Optionally, the information bit is an information bit whose reliability is higher than or equal to preset reliability. This indicates that the first disturbance value may be added to the LLR value of the information bit and/or the LLR value of the frozen bit. In this way, error correction performance can be improved.

With reference to the third aspect, in a possible implementation, that the first LLR value is determined based on the third LLR value includes: The first LLR value includes an LLR value of an intermediate layer node corresponding to an information bit whose reliability is higher than or equal to preset reliability, and the LLR value of the intermediate layer node is determined based on the third LLR value. This indicates that the first disturbance value may be added to the LLR value of the intermediate layer node. In this way, error correction performance can be improved.

With reference to the third aspect, in a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the symbol sequence.

In the foregoing embodiment, when the first disturbance value is the disturbance value generated online, it indicates that a process of generating the first disturbance value is not complex, and the first disturbance value may be quickly generated. When the first disturbance value is the Gaussian distribution noise value or the first disturbance value is determined based on the signal-to-noise ratio and/or the power of the symbol sequence, because an LLR value is related to residual phase noise and additive white noise that are obtained through phase noise estimation, and the residual phase noise and the additive white noise that are obtained through phase noise estimation are generally in Gaussian distribution, when the first disturbance value is the Gaussian distribution noise value or the first disturbance value is determined based on the signal-to-noise ratio and/or the power of the symbol sequence, the second LLR value determined based on the first disturbance value may be more in line with a change in an actual channel condition, so that error correction performance can be improved. When the first disturbance value is the preset disturbance value, processes of generating the first disturbance value in real time are reduced, so that decoding efficiency can be improved.

According to a fourth aspect, a decoding method is provided. The decoding method includes: determining a first LLR value and a second LLR value, where the first LLR value is determined based on a first symbol sequence corresponding to a code bit sequence, the second LLR value is obtained based on a second symbol sequence, the second symbol sequence is obtained by adding a first disturbance value to the first symbol sequence, and the first symbol sequence is different from the second symbol sequence; and performing decoding based on the first LLR value and the second LLR value to obtain a decoding result.

In the foregoing embodiment, decoding is performed based on the first LLR value and the second LLR value to obtain the decoding result, so that parallel decoding based on different LLR values is implemented. This can reduce time for decoding, reduce a decoding delay, and improve decoding efficiency. In addition, performing decoding based on the second LLR value can improve error correction performance.

Optionally, performing decoding based on the first LLR value and the second LLR value to obtain the decoding result includes: performing SCL decoding based on the first LLR value and the second LLR value to obtain the decoding result. A specific decoding scheme and a corresponding decoding process are not limited in this application.

In the foregoing embodiment, performing SCL decoding based on the second LLR value to obtain the decoding result can improve error correction performance. For example, error correction performance can still be ensured when L is set to a small value. In addition, when L is a small value, needed storage space is reduced. Therefore, a chip area can be further reduced, and hardware costs can be reduced.

With reference to the fourth aspect, in a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the first symbol sequence.

In the foregoing embodiment, when the first disturbance value is the disturbance value generated online, it indicates that a process of generating the first disturbance value is not complex, and the first disturbance value may be quickly generated. When the first disturbance value is the Gaussian distribution noise value or the first disturbance value is determined based on the signal-to-noise ratio and/or the power of the first symbol sequence, because an LLR value is related to residual phase noise and additive white noise that are obtained through phase noise estimation, and the residual phase noise and the additive white noise that are obtained through phase noise estimation are generally in Gaussian distribution, when the first disturbance value is the Gaussian distribution noise value or the first disturbance value is determined based on the signal-to-noise ratio and/or the power of the first symbol sequence, the second LLR value determined based on the first disturbance value may be more in line with a change in an actual channel condition, so that error correction performance can be improved. When the first disturbance value is the preset disturbance value, processes of generating the first disturbance value in real time are reduced, so that decoding efficiency can be improved.

According to a fifth aspect, a communication apparatus is provided. The apparatus includes a unit or a module configured to implement the method according to any one of the first aspect, the second aspect, the third aspect, or the fourth aspect.

According to a sixth aspect, a communication apparatus is provided. The apparatus includes a processor. The processor invokes a computer program stored in a memory, so that the method according to any one of the first aspect, the second aspect, the third aspect, or the fourth aspect is performed.

According to a seventh aspect, a computer-readable storage medium is provided. The computer-readable storage medium stores a computer program, and when the computer program is run, the method according to any one of the first aspect, the second aspect, the third aspect, or the fourth aspect is performed.

According to an eighth aspect, a chip is provided. The chip includes at least one processor and an interface. The processor is configured to read and execute instructions stored in a memory. When the instructions are run, the chip is enabled to perform the method according to any one of the first aspect, the second aspect, the third aspect, or the fourth aspect.

According to a ninth aspect, a computer program product including instructions is provided. When the computer program product runs on a computer, the method according to any one of the first aspect, the second aspect, the third aspect, or the fourth aspect is performed.

## BRIEF DESCRIPTION OF DRAWINGS

FIG. 1a is a diagram of a polar kernel;
FIG. 1b shows an example of a polar code factor graph;
FIG. 1c is a diagram of an SC decoding calculation process;
FIG. 1d is a diagram of decoding paths in SCL decoding;
FIG. 1e is a diagram of a decoding calculation process;
FIG. 2 is a diagram of a communication system according to an embodiment of this application;
FIG. 3 is a schematic flowchart of a decoding method according to an embodiment of this application;
FIG. 4 is a schematic flowchart of another decoding method according to an embodiment of this application;
FIG. 5 is a schematic flowchart of another decoding method according to an embodiment of this application;
FIG. 6 is a schematic flowchart of another decoding method according to an embodiment of this application;
FIG. 7 is a diagram of an effect according to an embodiment of this application;
FIG. 8 is a diagram of a structure of a communication apparatus according to an embodiment of this application;
FIG. 9 is a diagram of a simplified structure of a terminal device according to an embodiment of this application; and
FIG. 10 is a diagram of a simplified structure of a network device according to an embodiment of this application.

## DESCRIPTION OF EMBODIMENTS

For ease of understanding, some concepts related to embodiments of this application are described for reference by using the following examples. Details are as follows:

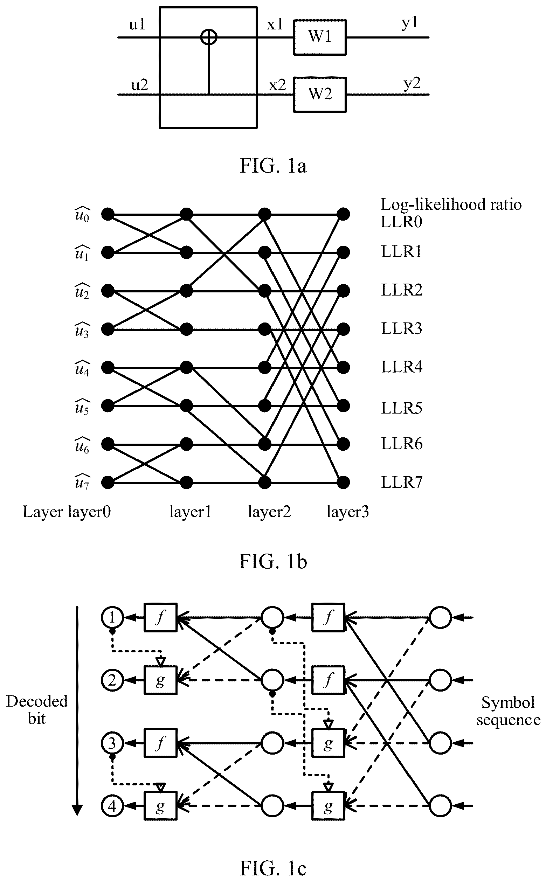

There may be a plurality of decoding schemes for a polar code, for example, successive cancellation (successive cancellation, SC) decoding and SCL decoding. In various decoding schemes for the polar code, calculation may be performed based on a butterfly network (which may also be referred to as a factor graph (factor graph)) of the polar code. A structure of the factor graph is related to a constructed structure of the polar code. For example, FIG. 1a is a diagram of a polar kernel. $u1$ and $u2$ are inputs, and $x1$ and $x2$ that are encoded may be expressed as $x1=u1+u2$ and $x2=u2$, where "+" represents modulo 2 addition.

After a polar kernel operation shown in FIG. 1a is performed, two new channels (W1 and W2) are obtained. A channel capacity of one channel decreases, and a channel capacity of the other channel increases. Therefore, after the polar kernel is repeatedly and iteratively invoked, theoretically, a channel capacity of a part of the channels may approach 1, and a channel capacity of another part of the channels may approach 0, so that error-free transmission can be theoretically implemented, provided that an information bit (that is, a bit for carrying information) is placed on the channel whose channel capacity approaches 1 and a known bit (that is, a frozen bit) is placed on the channel whose channel capacity approaches 0. A repeatedly cascaded polar kernel network may be referred to as a butterfly network or a factor graph. As shown in FIG. 1b, an LLR sequence includes eight LLRs: LLR0, LLR1, LLR2, LLR3, LLR4, LLR5, LLR6, and LLR7. The factor graph includes 3+1=4 layers (layer0, layer1, layer2, and layer3), and each layer includes eight nodes (black dots shown in the figure). Each crossed unit in the figure represents one polar kernel shown in FIG. 1a. $\widehat{u_0}$ to $\widehat{u_7}$ respectively represent estimated values of $u_0$ to $u_7$, and each of $u_0$ to $u_7$ is an information bit.

In SC decoding, LLRs of information bits are calculated one by one. For an information bit, if an LLR is greater than 0, the bit is 0; if the LLR is less than 0, the bit is 1. For a frozen bit, a decoding result is set to 0 regardless of a value of an LLR. For example, FIG. 1c is a diagram of an SC decoding calculation process. There are eight computing nodes in total in FIG. 1c. There are four F nodes and four G nodes, and the F node and the G node respectively correspond to an F operation and a G operation. For the operation for the F node, two LLR inputs on a right side of the F node are needed. For the operation for the G node, two LLR inputs on a right side of the G node are needed and an upper-level output is also used as an input. An output can be calculated only after input calculation is completed.

A simplified operation may be used for the F operation, and an F operation formula is:

$$F(a,b)=\text{sign}(a)\text{sign}(b)\min(|a|,|b|).$$

A simplified operation is used for the G operation, and a G operation formula is:

$$G(a,b,\hat{u}) = a(-1)^{\hat{u}} + b.$$

According to the foregoing calculation rule, in FIG. 1c, starting from the right side, decoded bits obtained by sequentially performing calculation are: ①->②->③->④, and decoding is completed.

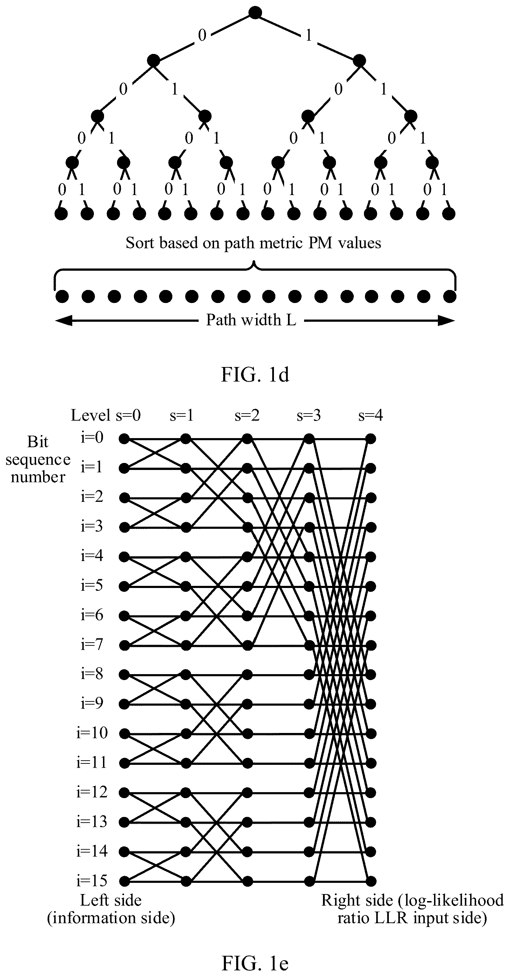

When SCL decoding is performed based on an LLR value, decoding results corresponding to 0 and 1 may be both stored as two branch decoding paths (which is referred to as path splitting for short). FIG. 1d is a diagram of decoding paths in an SCL decoding method. As shown in FIG. 1d, each layer represents one decoded bit. If a decoding result is 0, a path is developed along a left subtree. If the decoding result is 1, a path is developed along a right subtree. This may be referred to as path selection. When a total quantity of decoding paths exceeds a preset path width L (where L is an integer greater than or equal to 1), L paths with optimal PM values are selected and stored, and a path continues to be developed to decode a subsequent decoded bit. A PM value is for determining path quality, and the PM value is obtained through LLR value calculation. For a decoded bit at each level, the PM values of the L paths are sorted in ascending order, and a correct path is selected by using the PM values. This process is repeated until a last bit is decoded.

The following describes a decoding operation with reference to FIG. 1e. As shown in FIG. 1e, a right side is an LLR input side, for example, LLR0 to LLR15, and a left side is an information side, for example, $\widehat{u_0}$ to $\widehat{u_{15}}$. At the beginning of decoding, levels are sequentially s=4, s=3, s=2, s=1, and s=0. When SCL decoding is used, an F/G operation may be performed on the 16 LLRs at the level of s=4 to obtain eight LLRs at the level of s=3. In this case, an F/G operation continues to be performed on the eight LLRs at the level of s=3 to obtain four LLRs at the level of s=2. An F/G operation continues to be performed on the four LLRs at the level of s=2 to obtain two LLRs at the level of s=1. An F/G operation continues to be performed on the two LLRs at the level of s=1 to obtain one LLR at the level of s=0, and path splitting is performed at the level of s=0 bit by bit. At the beginning of decoding, an LLR is read in, and probability transfer is performed to obtain an LLR value of a first decoded bit. A decision is made on the LLR value to obtain a decoding result of the first decoded bit. A decision bit value of the first decoded bit is used as an input of a second decoded bit, to calculate an LLR value of the second decoded bit, until calculation performed on all decoded bits at the level of s=0 is completed. Decoded bits include a frozen bit and an information bit. For a frozen bit position, a decision bit value is 0 regardless of a value of an LLR. For an information bit position, there may be two decision bit values: 0 and 1, so that two paths can be obtained through splitting.

The following describes a system architecture and a service scenario in embodiments of this application. It should be noted that the system architecture and the service scenario described in this application are intended to describe technical solutions in this application more clearly, but constitutes no limitation on the technical solutions provided in this application. A person of ordinary skill in the art may learn that the technical solutions provided in this application are also applicable to similar technical problems as a system architecture evolves and a new service scenario emerges.

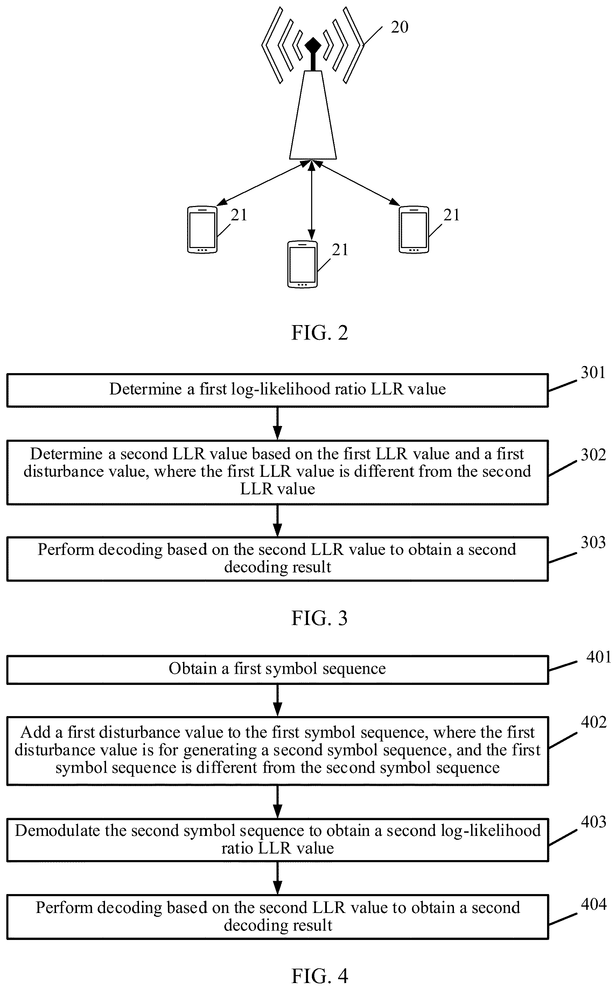

FIG. 2 is a diagram of a communication system according to an embodiment of this application. As shown in FIG. 2, the communication system may include a network device 20 and one or more terminal devices (for example, a terminal device 21 in FIG. 2) communicating with the network device 20. The following describes in detail each device related to the communication system.

1. Network device

In this application, the network device may be a terrestrial network (terrestrial network, TN) device or a non-terrestrial network (non-terrestrial network, NTN) device.

The terrestrial network device is an entity that is on a network side and that is configured to send a signal, receive a signal, or send a signal and receive a signal. The terrestrial network device may be an apparatus that is deployed in a radio access network (radio access network, RAN) and that provides a wireless communication function for a terminal device. For example, the terrestrial network device may be a transmission reception point (transmission reception point, TRP), a base station, or control nodes in various forms, for example, a network controller, a radio controller, or a radio controller in a cloud radio access network (cloud radio access network, CRAN) scenario. Specifically, the terrestrial network device may be various forms of macro base stations, micro base stations (which are also referred to as small cells), relay stations, access points (access point, AP), radio network controllers (radio network controller, RNC), NodeBs (NodeB, NB), base station controllers (base station controller, BSC), base transceiver stations (base transceiver station, BTS), home base stations (for example, a home evolved NodeB, or a home NodeB, HNB), baseband units (baseband unit, BBU), transmission reception points (transmission reception point, TRP), transmitting points (transmitting point, TP), mobile switching centers, satellites, uncrewed aerial vehicles, or the like, or may be an antenna panel of a base station. The control node may be connected to a plurality of base stations, and configure resources for a plurality of terminals covered by the plurality of base stations. A device having a base station function may have different names in systems using different radio access technologies. For example, the base station may be a gNB in a 5th generation mobile communication technology (5th generation mobile network, 5G), a network side device in a network after 5G, a terrestrial network device in a future evolved public land mobile (communication) network (public land mobile network, PLMN), or a device that undertakes a base station function in device-to-device (Device-to-Device, D2D) communication, machine-to-machine (Machine-to-Machine, M2M) communication, or internet of vehicles communication. A specific name of the terrestrial network device is not limited in this application.

The non-terrestrial network device may provide a radio access service for a terminal device, schedule a radio resource for the accessed terminal device, and provide a reliable radio transmission protocol, a reliable data encryption protocol, and the like. The non-terrestrial network device may be a base station used for wireless communication, such as an artificial earth satellite and a high-altitude aircraft, for example, a medium earth orbit (medium earth orbit, MEO) satellite or a low earth orbit (low earth orbit, LEO) satellite in a non-geostationary earth orbit (non-geostationary earth orbit, NGEO), or a high altitude platform station (high altitude platform station, HAPS). The terrestrial network device may have a relay forwarding function to transparently transmit (transparent) a wireless signal to the terminal device and so on.

In a possible implementation, the network device may alternatively be an open access network (open RAN, O-RAN or ORAN), a cloud radio access network (cloud radio access network, CRAN), or the like.

In a possible implementation, a plurality of network devices collaborate to assist the terminal in implementing radio access, and different network devices respectively implement some functions of the base station. For example, the network device may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a BBU. The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

In different systems, the CU (or the CU-CP and the CU-UP), the DU, or the RU may also have different names, but a person skilled in the art may understand meanings thereof. For example, in an ORAN system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP or the CU-UP), the DU, and the RU in this application may be implemented by using a software module, a hardware module, or a combination of the software module and the hardware module.

A device form of the network device is not limited in embodiments of this application. An apparatus configured to implement a function of the network device may be the network device, or may be an apparatus that can support the network device in implementing the function, for example, a chip system. The apparatus may be installed in the network device or used in cooperation with the network device. In embodiments of this application, the chip system may include a chip, or may include a chip and another discrete component.

2. Terminal device

The terminal device is an entity that is on a user side and that is configured to receive a signal, send a signal, or receive a signal and send a signal. The terminal device may be configured to provide one or both of a voice service and a data connectivity service for a user. The terminal device may be a device that has a wireless transceiver function and that may cooperate with a network device to provide a communication service for a user. Specifically, the terminal device may refer to user equipment (user equipment, UE), an access terminal, a subscriber unit, a subscriber station, a mobile station, a remote station, a remote terminal, a mobile device, a terminal, a wireless communication device, a user agent, a user apparatus, or a roadside unit (roadside unit, RSU). The terminal device may alternatively be an uncrewed aerial vehicle, an internet of things (internet of things, IoT) device, a station (station, ST) in a WLAN, a cellular phone (cellular phone), a smartphone (smartphone), a cordless phone, a wireless data card, a tablet computer, a session initiation protocol (session initiation protocol, SIP) phone, a wireless local loop (wireless local loop, WLL) station, a personal digital assistant (personal digital assistant, PDA) device, a laptop computer (laptop computer), a machine type communication (machine type communication, MTC) terminal, a handheld device having a wireless communication function, a computing device or another processing device connected to a wireless modem, a vehicle-mounted device, a wearable device (which may also referred to as a wearable intelligent device), a virtual reality (virtual reality, VR) terminal, an augmented reality (augmented reality, AR) terminal, a wireless terminal in industrial control (industrial control), a wireless terminal in self-driving (self-driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like. The terminal device may alternatively be a device-to-device (device-to-device, D2D) device, for example, an electricity meter or a water meter. The terminal device may alternatively be a terminal in a 5G system, or a terminal in a next generation communication system. This is not limited in embodiments of this application.

A device form of the terminal is not limited in embodiments of this application. An apparatus configured to implement a function of the terminal device may be the terminal device, or may be an apparatus that can support the terminal device in implementing the function, for example, a chip system. The apparatus may be installed in the terminal device or used in cooperation with the terminal device. In embodiments of this application, the chip system may include a chip, or may include a chip and another discrete component.

It should be noted that the communication system shown in FIG. 2 does not constitute a limitation on a communication system to which embodiments of this application are applicable. It is understood that a decoding method provided in embodiments of this application is applicable to communication systems of various standards, for example, a long term evolution (long term evolution, LTE) architecture, 5G, a wireless local area network (wireless local area network, WLAN) system, a V2X communication system, LTE-vehicle to everything (LTE-vehicle, LTE-V), vehicle to vehicle (vehicle to vehicle, V2V), machine type communication (machine type communication, MTC), LTE-machine to machine (LTE-machine to machine, LTE-M), and an internet of things. The technical solutions in embodiments of this application may be further applied to another future communication system, for example, a 6G communication system. In the future communication system, a same function may be maintained, but a name may be changed.

The following specifically describes, with reference to FIG. 2, the decoding method provided in embodiments of this application. It should be noted that the decoding method provided in this application may be performed by the network device, a chip in the network device, the terminal device, or a chip in the terminal device in FIG. 2. This is not limited herein. The following uses an example in which an execution entity is a terminal device for description.

Currently, a polar code may be decoded by using an SCL algorithm. When the SCL algorithm is used for decoding, L decoding paths are stored. At the end of decoding, the L decoding paths are sorted based on PM values, and a decoding result corresponding to a decoding path with a lowest PM value is selected as a final decoding result, or a cyclic redundancy check (cyclic redundancy check, CRC) is performed, and a path that succeeds in CRC may be selected as a final decoding result. Generally, a decoding delay and the like of the SCL algorithm increase linearly with a value of L. Therefore, to improve decoding efficiency, a small value of L is usually used in an actual application process. However, this may limit error correction performance of the polar code. In addition, when an SC algorithm is used for decoding, a disturbance value may be added to a received symbol. However, due to poor performance of the SC algorithm, even though the disturbance value is added and decoding is performed repeatedly for a plurality of times, the error correction performance of the polar code is still not high. To resolve the problem, in FIG. 3, a solution of determining a second LLR value based on a first LLR value and a first disturbance value, and performing decoding based on the obtained second LLR value is provided. In FIG. 4, a solution of adding a first disturbance value to a first symbol sequence to generate a second symbol sequence, and performing decoding based on a second LLR value obtained by demodulating the second symbol sequence is provided.

The following first describes FIG. 3. FIG. 3 is a schematic flowchart of a decoding method according to an embodiment of this application. As shown in FIG. 3, the method includes but is not limited to the following steps.

301: A terminal device determines a first LLR value.

In a possible implementation, step 301 may include: The terminal device obtains a symbol sequence, where the symbol sequence corresponds to a code bit sequence. The terminal device demodulates the symbol sequence to obtain a third LLR value. The terminal device determines the first LLR value based on the third LLR value. This indicates that the first LLR value may be determined based on the third LLR value obtained by demodulating the symbol sequence corresponding to the code bit sequence. This indicates a specific position at which the first disturbance value may be added.

In this application, the symbol sequence may include one or more symbols.

In this application, the code bit sequence may be determined based on an information bit sequence and a frozen bit sequence. The information bit sequence may include one or more information bits, and the frozen bit sequence may include one or more frozen bits.

Optionally, that the terminal device obtains the symbol sequence may be understood as that the terminal device receives the symbol sequence from another device (including a network device or another terminal device).

Optionally, that the terminal device demodulates the symbol sequence to obtain the third LLR value may be understood as that the terminal device obtains, by performing calculation based on a channel noise variance, a third LLR value corresponding to at least one bit in the code bit sequence corresponding to the symbol sequence. In an example, when BPSK modulation is used, a third LLR value corresponding to one bit in the code bit sequence may be calculated by using the following formula:

$$\mathrm{LLR(x)} = \ln \frac{p(y|x=0)}{p(y|x=1)} = \frac{2y}{\sigma^2}$$

x represents the bit in the code bit sequence, LLR(x) represents the third LLR value corresponding to the bit, $p(y|x=0)$ represents a probability that a symbol in the symbol sequence is y when a value of $x$ is 0, $p(y|x=1)$ represents a probability that the symbol is y when a value of the bit is 1, and $\sigma^2$ represents a channel noise variance. Another modulation scheme may alternatively be used for demodulation to obtain a corresponding LLR value. A specific modulation scheme is not limited in this application.

The first LLR value may be implemented in, but not limited to, any one of the following manners. Detailed descriptions are as follows:

1: The first LLR value includes the third LLR value.
2: The terminal device determines an LLR value of the information bit and/or an LLR value of the frozen bit based on the third LLR value, and the first LLR value includes the LLR value of the information bit and/or the LLR value of the frozen bit. Optionally, the information bit is an information bit whose reliability is higher than or equal to preset reliability. The preset reliability may be predefined or preconfigured in a protocol, or may be configured by another device (including the network device or another terminal device). This is not limited herein.
3: The terminal device determines, based on the third LLR value, an LLR value of an intermediate layer node corresponding to an information bit whose reliability is higher than or equal to preset reliability, where the first LLR value includes the LLR value of the intermediate layer node. In this application, the intermediate layer node may be, for example, any one or more nodes at the levels of s=s=1, s=2, and s=3 in FIG. 1e.

In any one of the foregoing implementations, a specific position at which the first disturbance value may be added is provided. This can improve error correction performance.

In a possible implementation, the first LLR value mentioned in any one of the foregoing implementations may be understood as an LLR value obtained in an intermediate process of SCL decoding performed by the terminal device.

302: The terminal device determines a second LLR value based on the first LLR value and the first disturbance value, where the first LLR value is different from the second LLR value. This may also be understood as that the terminal device adds the first disturbance value to the first LLR value, and the first disturbance value is for generating the second LLR value.

Optionally, that the first LLR value is different from the second LLR value may be understood as but is not limited to any one of the following understandings.

1: When the first LLR value includes the third LLR value, a third LLR value of at least one bit in the code bit sequence is different from a second LLR value of the corresponding bit. For example, the code bit sequence includes a 1st bit and a 2nd bit, a third LLR value of the 1st bit is different from a second LLR value of the 1st bit, and/or a third LLR value of the 2nd bit is different from a second LLR value of the 2nd bit.
2: When the first LLR value includes the LLR value of the information bit, and there are one or more information bits, an LLR value of at least one of the one or more information bits is different from a second LLR value of the corresponding information bit. For example, a plurality of information bits include a 1st information bit and a 2nd information bit, an LLR value of the 1st information bit is different from a second LLR value of the 1st bit, and/or an LLR value of the 2nd information bit is different from a second LLR value of the 2nd information bit.
3: When the first LLR value includes the LLR value of the frozen bit, and there are one or more frozen bits, an LLR value of at least one of the one or more frozen bits is different from a second LLR value of the corresponding frozen bit. For example, a plurality of frozen bits include a 1st frozen bit and a 2nd frozen bit, an LLR value of the 1st frozen bit is different from a second LLR value of the 1st bit, and/or an LLR value of the 2nd frozen bit is different from a second LLR value of the 2nd frozen bit.
4: When the first LLR value includes the LLR value of the information bit and the LLR value of the frozen bit, the manner 2 or the manner 3 may be separately used as a manner of understanding that "the first LLR value is different from the second LLR value", or a new manner formed by combining the manner 2 and the manner 3 is used as a manner of understanding that "the first LLR value is different from the second LLR value".
5: When the first LLR value includes the LLR value of the intermediate layer node, and there may be one or more intermediate layer nodes, an LLR value of at least one of the one or more intermediate layer nodes is different from a second LLR value of the corresponding intermediate layer node. With reference to FIG. 1e, a plurality of intermediate layer nodes may

include a 1st node (in an order from top to bottom) at the level of s=1 and a 1st node (in an order from top to bottom) at the level of s=2. An LLR value of the 1st node at the level of s=1 is different from a second LLR value of the 1st node at the level of s=1, and/or an LLR value of the 1st node at the level of s=2 is different from a second LLR value of the 1st node at the level of s=2.

Optionally, the method further includes: The terminal device performs decoding based on the third LLR value to obtain a first decoding result. Step 302 may include: When the first decoding result is incorrect, the terminal device determines the second LLR value based on the first LLR value and the first disturbance value. Performing decoding based on the third LLR value to obtain the first decoding result may include: performing SCL decoding based on the third LLR value to obtain the first decoding result. A specific decoding scheme is not limited in this application. In the foregoing embodiment, when the first decoding result is incorrect, the second LLR value is determined based on the first LLR value and the first disturbance value. This can avoid a problem of a waste of resources caused by repeated decoding based on the second LLR value that is determined based on the first LLR value and the first disturbance value when the first decoding result is correct.

In this application, that a decoding result (for example, the first decoding result) is incorrect may be understood as that CRC on a decoded bit corresponding to a path with a largest PM value in L paths fails. For example, the terminal device may perform SCL decoding based on the third LLR value to obtain the L paths. Assuming that L is 8, the terminal device may sort the eight paths in ascending order of PM values, for example, a path 1 to a path 8. The terminal device may first perform CRC on a decoded bit corresponding to the path 1; if the check fails, the terminal device may perform CRC on a decoded bit corresponding to the path 2; if the CRC performed on the decoded bit corresponding to the path 2 fails, the terminal device performs CRC on a decoded bit corresponding to the path 3; and so on. When CRC performed on a decoded bit corresponding to the path 8 fails, the terminal device may consider that the first decoding result is incorrect.

In a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the symbol sequence. When the first disturbance value is the disturbance value generated online, it indicates that a process of generating the first disturbance value is not complex, and the first disturbance value may be quickly generated. When the first disturbance value is the Gaussian distribution noise value or the first disturbance value is determined based on the signal-to-noise ratio and/or the power of the symbol sequence, because an LLR value is related to residual phase noise and additive white noise that are obtained through phase noise estimation, and the residual phase noise and the additive white noise that are obtained through phase noise estimation are generally in Gaussian distribution, when the first disturbance value is the Gaussian distribution noise value or the first disturbance value is determined based on the signal-to-noise ratio and/or the power of the symbol sequence, the second LLR value determined based on the first disturbance value may be more in line with a change in an actual channel condition, so that error correction performance can be improved. When the first disturbance value is the preset disturbance value, processes of generating the first disturbance value in real time are reduced, so that decoding efficiency can be improved.

303: The terminal device performs decoding based on the second LLR value to obtain a second decoding result.

In a possible implementation, step 303 may include: The terminal device performs SCL decoding based on the second LLR value to obtain a second decoding result. A specific decoding process is not limited in this application. For example, the terminal device may perform SCL decoding based on the second LLR value to obtain L paths. Assuming that L is 8, the terminal device may sort the eight paths in ascending order of PM values, for example, a path 1 to a path 8. Detailed descriptions are as follows:

1: The second decoding result may be a result corresponding to the path 1.
2: The terminal device may perform CRC on the result corresponding to the path 1; if the check succeeds, the terminal device may use the result corresponding to the path 1 as the second decoding result; if the check fails, the terminal device may perform CRC on a result corresponding to the path 2; if the CRC performed on the result corresponding to the path 2 succeeds, the terminal device may use the result corresponding to the path 2 as the second decoding result; if the CRC performed on the result corresponding to the path 2 fails, the terminal device performs CRC on a result corresponding to the path 3; and so on.

In the foregoing manner 1 or manner 2, error correction performance can still be ensured when L is set to a small value. In addition, because L is set to a small value, needed storage space is reduced. Therefore, a chip area can be further reduced, and hardware costs can be reduced.

In the foregoing embodiment, the second LLR value may be determined based on the first LLR value and the first disturbance value, and decoding is performed based on the second LLR value. In this way, error correction performance can be improved.

Optionally, in the embodiment shown in FIG. 3, when a check result of the second decoding result is incorrect, the terminal device may add a second disturbance value to the first LLR value and perform decoding again. A process is similar to that of adding the first disturbance value to the first LLR value and performing decoding based on the second LLR value. Details are not described herein again.

In this application, the second disturbance value is a disturbance value generated online; or the second disturbance value is a Gaussian distribution noise value; or the second disturbance value is a preset disturbance value; or the second disturbance value is determined based on the signal-to-noise ratio and/or the power of the symbol sequence. The first disturbance value and the second disturbance value may be the same or different. For example, the values may be the same or different. For example, the first disturbance value and the second disturbance value are same or different disturbance values generated online. For another example, the first disturbance value is a preset disturbance value, the second disturbance value is determined based on the signal-to-noise ratio and/or the power of the symbol sequence, and the first disturbance value and the second disturbance value are different values.

FIG. 4 is a schematic flowchart of another decoding method according to an embodiment of this application. As shown in FIG. 4, the method includes but is not limited to the following steps.

401: A terminal device obtains a first symbol sequence, for example, receives the first symbol sequence from a network device or another terminal device.

The first symbol sequence corresponds to a code bit sequence. The first symbol sequence and the code bit sequence are respectively similar to the symbol sequence and the code bit sequence in step 301 in FIG. 3. Details are not described herein again.

402: The terminal device adds a first disturbance value to the first symbol sequence, where the first disturbance value is for generating a second symbol sequence, and the first symbol sequence is different from the second symbol sequence.

For the first disturbance value, refer to the related descriptions of step 302 in FIG. 3. Details are not described herein again.

In this application, that the first symbol sequence and the second symbol sequence are different may be understood as that at least one symbol in the first symbol sequence is different from at least one symbol in the second symbol sequence.

In a possible implementation, the method further includes: The terminal device demodulates the first symbol sequence to obtain a first LLR value. The terminal device performs decoding based on the first LLR value to obtain a first decoding result. Step 402 may include: When the first decoding result is incorrect, the terminal device adds the first disturbance value to the first symbol sequence. This can avoid a problem of a waste of resources caused by repeated decoding based on the second symbol sequence that is obtained by adding the first disturbance value to the first symbol sequence when the first decoding result is correct.

A process in which the terminal device demodulates the first symbol sequence to obtain the first LLR value is similar to a process in which the terminal device demodulates the symbol sequence to obtain the third LLR value in FIG. 3. Details are not described herein again.

Optionally, that the terminal device performs decoding based on the first LLR value to obtain the first decoding result may include: The terminal device performs SCL decoding based on the first LLR value to obtain the first decoding result. A specific decoding scheme and a corresponding decoding process are not limited in this application.

403: The terminal device demodulates the second symbol sequence to obtain a second LLR value.

Step 403 is similar to that the terminal device demodulates the symbol sequence to obtain the third LLR value in FIG. 3. Details are not described herein again.

404: The terminal device performs decoding based on the second LLR value to obtain a second decoding result.

Step 403 is similar to step 303 in FIG. 3. Details are not described herein again.

In the foregoing embodiment, the first disturbance value is added to the first symbol sequence to obtain the second symbol sequence, so that the second symbol sequence may be demodulated to obtain the second LLR value, and decoding is performed based on the second LLR value. In this way, error correction performance can be improved.

Optionally, in the embodiment shown in FIG. 4, when a check result of the second decoding result is incorrect, the terminal device may add a second disturbance value to the first symbol sequence and perform decoding again. A process is similar to a process of adding the first disturbance value to the first symbol sequence and performing decoding based on the second LLR value. Details are not described herein again. For the second disturbance value, refer to the related descriptions of step 303 in FIG. 3. Details are not described herein again.

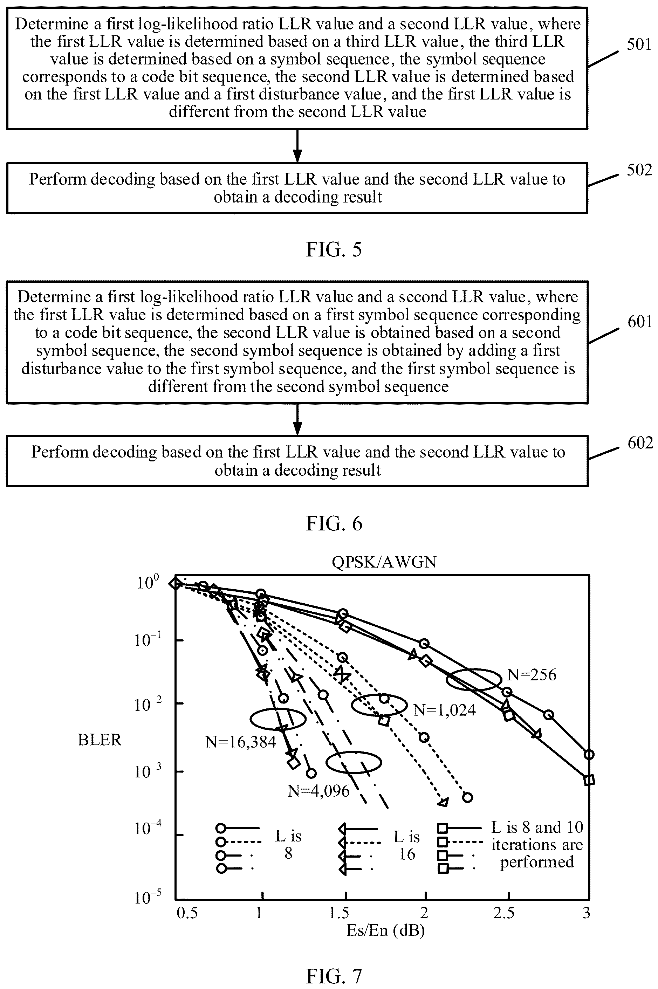

Currently, a delay of an SCL algorithm increases linearly with a value of L. To resolve this problem, in FIG. 5 and FIG. 6, solutions of performing parallel decoding based on a first LLR value and a second LLR value are respectively provided.

The following first describes FIG. 5. FIG. 5 is a schematic flowchart of another decoding method according to an embodiment of this application. As shown in FIG. 5, the method includes but is not limited to the following steps.

501: A terminal device determines a first LLR value and a second LLR value, where the first LLR value is determined based on a third LLR value, the third LLR value is determined based on a symbol sequence, the symbol sequence corresponds to a code bit sequence, the second LLR value is determined based on the first LLR value and a first disturbance value, and the first LLR value is different from the second LLR value.

Optionally, that the third LLR value is determined based on the symbol sequence may be understood as that the third LLR value is obtained by demodulating the symbol sequence. For a specific process, refer to the descriptions of step 301 in FIG. 3. Details are not described herein again. In a possible implementation, the symbol sequence may be obtained from another device (including a network device or another terminal device).

For the symbol sequence and the code bit sequence, refer to the related descriptions in step 301 in FIG. 3. Details are not described herein again.

Optionally, that the first LLR value is determined based on the third LLR value may be understood as any one of the following:

> 1: The first LLR value includes the third LLR value.
> 2: The first LLR value includes an LLR value of an information bit and/or an LLR value of a frozen bit, and the LLR value of the information bit and/or the LLR value of the frozen bit are/is determined based on the third LLR value. Optionally, the information bit is an information bit whose reliability is higher than or equal to preset reliability.
> 3: The first LLR value includes an LLR value of an intermediate layer node corresponding to an information bit whose reliability is higher than or equal to preset reliability, and the LLR value of the intermediate layer node is determined based on the third LLR value.

For the third LLR value, the information bit, the frozen bit, the intermediate layer node, and the like mentioned in step 501, refer to the related descriptions in FIG. 3. Details are not described herein again.

502: The terminal device performs decoding based on the first LLR value and the second LLR value to obtain a decoding result.

In a possible implementation, the terminal device performs SCL decoding based on the first LLR value and the second LLR value to obtain the decoding result. For example, the terminal device may perform SCL decoding based on the first LLR value and the second LLR value to obtain L paths. Assuming that L is 8, the terminal device may sort the eight paths in ascending order of PM values, for example, a path 1 to a path 8. Detailed descriptions are as follows:

> 1: The decoding result may be a result corresponding to the path 1.
> 2. The terminal device may perform CRC on the result corresponding to the path 1; if the check succeeds, the terminal device may use the result corresponding to the path 1 as the decoding result; if the check fails, the terminal device may perform CRC on a result corresponding to the path 2; if the CRC performed on the result corresponding to the path 2 succeeds, the terminal device may use the result corresponding to the path 2 as the decoding result; if the CRC performed on the result corresponding to the path 2 fails, the terminal device performs CRC on a result corresponding to the path 3; and so on.

In the foregoing embodiment, decoding is performed based on the first LLR value and the second LLR value to obtain the decoding result, so that parallel decoding based on different LLR values is implemented. This can reduce time for decoding, reduce a decoding delay, and improve decoding efficiency. In addition, performing decoding based on the second LLR value can improve error correction performance.

Optionally, in the embodiment shown in FIG. 5, when the decoding result is incorrect, the terminal device may add a second disturbance value to the first LLR value and perform decoding again. For the second disturbance value, refer to the related descriptions of step 303 in FIG. 3. Details are not described herein again.

FIG. 6 is a schematic flowchart of another decoding method according to an embodiment of this application. As shown in FIG. 6, the method includes but is not limited to the following steps.

601: The terminal device determines a first LLR value and a second LLR value, where the first LLR value is determined based on a first symbol sequence corresponding to a code bit sequence, the second LLR value is obtained based on a second symbol sequence, the second symbol sequence is obtained by adding a first disturbance value to the first symbol sequence, and the first symbol sequence is different from the second symbol sequence.

The first symbol sequence and the code bit sequence are respectively similar to the symbol sequence and the code bit sequence in step 301 in FIG. 3. Details are not described herein again. In addition, for the first disturbance value, refer to the related descriptions of step 302 in FIG. 3. Details are not described herein again.

Optionally, that the first LLR value is determined based on the first symbol sequence corresponding to the code bit sequence may be understood as that the first LLR value is obtained by demodulating the first symbol sequence. For a specific process, refer to the descriptions of step 301 in FIG. 3. Details are not described herein again. In a possible implementation, the first symbol sequence may be obtained from another device (including a network device or another terminal device).

602: The terminal device performs decoding based on the first LLR value and the second LLR value to obtain a decoding result.

Step 602 is similar to step 502 in FIG. 5. Details are not described herein again.

In the foregoing embodiment, decoding is performed based on the first LLR value and the second LLR value to obtain the decoding result, so that parallel decoding based on different LLR values is implemented. This can reduce time for decoding, reduce a decoding delay, and improve decoding efficiency. In addition, performing decoding based on the second LLR value can improve error correction performance.

Optionally, in the embodiment shown in FIG. 6, when the decoding result is incorrect, the terminal device may add a second disturbance value to the first LLR value and perform decoding again. For the second disturbance value, refer to the related descriptions of step 303 in FIG. 3. Details are not described herein again.

With reference to FIG. 7, the following describes an effect achieved by "performing decoding based on the second LLR value" in this solution. In FIG. 7, a horizontal coordinate is a signal-to-noise ratio (signal-to-noise ratio, SNR), Es is energy of a signal, En is power spectral density of noise, and a vertical coordinate is a block error rate (block error rate, BLER). In FIG. 7, polar codes whose code lengths are 256, 1,024, 4,096, and 16,384 (that is, N=256, 1,024, 4,096, and 16,384) use a same modulation scheme and a same disturbance value. The modulation scheme is quadrature phase shift keying (quadrature phase shift keying, QPSK), a channel is an additive white Gaussian noise (additive white Gaussian noise, AWGN) channel, and a code rate is 1/2. It can be learned that, as a code length increases and a gain stabilizes, performance of twice a list size may be achieved with a small quantity of iterations. Specifically, when the list size is 8 (that is, L is 8), for performance that may be achieved by performing SCL decoding on the polar codes whose code lengths are 256, 1,024, 4,096, and 16,384, refer to straight line plus circle, dotted line plus circle, short line-dotted line-short line plus circle, and short line-dotted line-dot line plus circle in FIG. 7. However, as a code length increases, performance decreases. When L is 16, for performance that may be achieved by performing SCL decoding on the polar codes whose code lengths are 256, 1,024, 4,096, and 16,384, refer to straight line plus triangle, dotted line plus triangle, short line-dotted line-short line plus triangle, and short line-dotted line-dot line plus triangle in FIG. 7. However, for polar codes of a same code length, performance of a list size of 16 (that is, L is 16) may also be achieved after 10 iterations. For example, for the polar code whose code length is 256, a value used for L is 8. However, after 10 iterations, straight line plus rectangle in FIG. 7 almost overlaps straight line plus triangle in FIG. 7. For another example, for the polar code whose code length is 1,024, a value used for L is 8. However, after 10 iterations, dotted line plus rectangle in FIG. 7 almost overlaps dotted line plus triangle in FIG. 7, and the rest parts are similar. One iteration may be understood as adding a disturbance value to the first LLR value and performing SCL decoding.

It should be noted that, to implement the foregoing function, the foregoing device includes a corresponding hardware structure and/or a corresponding software module for performing the function. A person skilled in the art should easily be aware that, in combination with units and algorithm steps of the examples described in embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

In embodiments of this application, the terminal device or the network device may be divided into functional modules based on the foregoing method examples. For example, each functional module may be obtained through division based on a corresponding function, or two or more functions may be integrated into one processing module. The integrated module may be implemented in a form of hardware, or may be implemented in a form of a software functional module. It should be noted that, in embodiments of this application, module division is an example, and is merely a logical function division. In actual implementation, another division manner may be used.

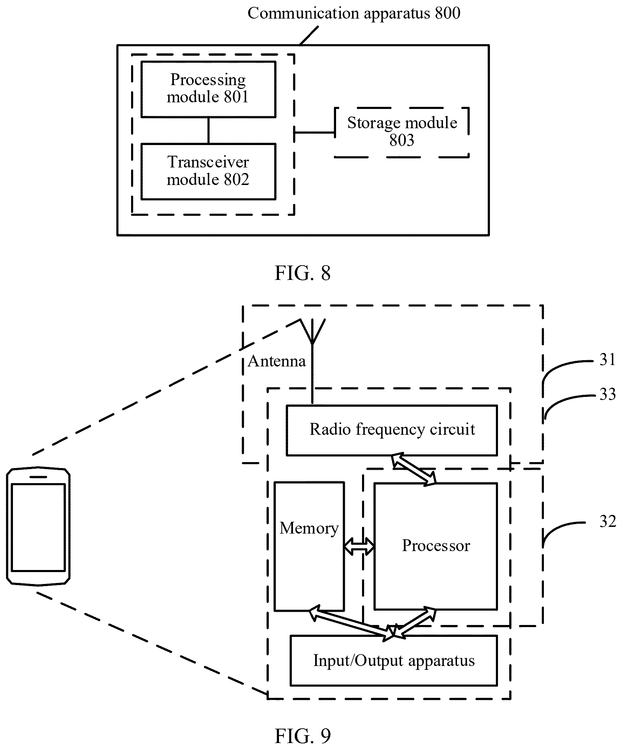

FIG. 8 is a diagram of a structure of a communication apparatus according to an embodiment of this application. The communication apparatus 800 may be used in the method shown in any one of the foregoing embodiments in FIG. 3 to FIG. 6. As shown in FIG. 8, the communication apparatus 800 includes a processing module 801 and a transceiver module 802. The processing module 801 may be one or more processors, and the transceiver module 802 may be a transceiver or a communication interface. The communication apparatus may be configured to implement a function of the terminal device or the network device in any one of the foregoing method embodiments, or configured to implement a function of a network element in any one of the foregoing method embodiments. The network element or network function may be a network element in a hardware device, may be a software function running on dedicated hardware, or may be a virtualized function instantiated on a platform (for example, a cloud platform). Optionally, the communication apparatus 800 may further include a storage module 803, configured to store program code and data that are of the communication apparatus 800.

In an instance, when the communication apparatus is used as the terminal device or a chip used in the terminal device, the communication apparatus performs the steps performed by the terminal device in the foregoing method embodiments. The transceiver module 802 is configured to support communication with the network device and the like. The transceiver module specifically performs a sending and/or receiving action performed by the terminal device in any one of embodiments shown in FIG. 3 to FIG. 6, for example, supports the terminal device in performing another process of the technology described in this specification. The processing module 801 may be configured to support the communication apparatus 800 in performing a processing action in the foregoing method embodiments, for example, support the terminal device in performing step 302, and/or another process of the technology described in this specification.

For example, the processing module 801 is configured to determine a first LLR value; the processing module 801 is configured to determine a second LLR value based on the first LLR value and the first disturbance value, where the first LLR value is different from the second LLR value; and the processing module 801 is further configured to perform decoding based on the second LLR value to obtain a second decoding result.

In a possible implementation, during determining of the first LLR value, the transceiver module 802 is configured to obtain a symbol sequence, where the symbol sequence corresponds to a code bit sequence; the processing module 801 is configured to demodulate the symbol sequence to obtain a third LLR value; and the processing module 801 is further configured to determine the first LLR value based on the third LLR value.

In a possible implementation, the first LLR value includes the third LLR value.

In a possible implementation, when determining the first LLR value based on the third LLR value, the processing module 801 is configured to determine an LLR value of an information bit and/or an LLR value of a frozen bit based on the third LLR value, where the first LLR value includes the LLR value of the information bit and/or the LLR value of the frozen bit.

In a possible implementation, when determining the first LLR value based on the third LLR value, the processing module 801 is configured to determine, based on the third LLR value, an LLR value of an intermediate layer node corresponding to an information bit whose reliability is higher than or equal to preset reliability, where the first LLR value includes the LLR value of the intermediate layer node.

In a possible implementation, the processing module 801 is further configured to perform decoding based on the third LLR value to obtain a first decoding result; when determining the second LLR value based on the first LLR value and the first disturbance value, the processing module 801 is configured to: when the first decoding result is incorrect, determine the second LLR value based on the first LLR value and the first disturbance value.

In a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the symbol sequence.

In a possible implementation, when performing decoding based on the second LLR value to obtain the second decoding result, the processing module 801 is configured to perform SCL decoding based on the second LLR value to obtain the second decoding result.

For another example, the transceiver module 802 is configured to obtain a first symbol sequence, where the first symbol sequence corresponds to the code bit sequence; the processing module 801 is configured to add the first disturbance value to the first symbol sequence, where the first disturbance value is for generating a second symbol sequence, and the first symbol sequence is different from the second symbol sequence; the processing module 801 is further configured to demodulate the second symbol sequence to obtain the second LLR value; and the processing module 801 is further configured to perform decoding based on the second LLR value to obtain the second decoding result.

In a possible implementation, the processing module 801 is further configured to demodulate the first symbol sequence to obtain the first LLR value; the processing module 801 is further configured to perform decoding based on the first LLR value to obtain the first decoding result; and when adding the first disturbance value to the first symbol, the processing module 801 is configured to: when the first decoding result is incorrect, add the first disturbance value to the first symbol sequence.

In a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the first symbol sequence.

In a possible implementation, when performing decoding based on the second LLR value to obtain the second decoding result, the processing module 801 is configured to perform SCL decoding based on the second LLR value to obtain the second decoding result.

For another example, the processing module 801 is configured to determine the first LLR value and the second LLR value, where the first LLR value is determined based on the third LLR value, the third LLR value is determined based on the symbol sequence, the symbol sequence corresponds to the code bit sequence, the second LLR value is determined based on the first LLR value and the first disturbance value, and the first LLR value is different from the second LLR value. The processing module 801 is further configured to perform decoding based on the first LLR value and the second LLR value to obtain the decoding result.

In a possible implementation, the first LLR value includes the third LLR value.

In a possible implementation, that the first LLR value is determined based on the third LLR value includes: The first LLR value includes an LLR value of an information bit and/or an LLR value of a frozen bit, and the LLR value of the information bit and/or the LLR value of the frozen bit are/is determined based on the third LLR value.

In a possible implementation, that the first LLR value is determined based on the third LLR value includes: The first LLR value includes an LLR value of an intermediate layer node corresponding to an information bit whose reliability is higher than or equal to preset reliability, and the LLR value of the intermediate layer node is determined based on the third LLR value.

In a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the symbol sequence.

In a possible implementation, when performing decoding based on the first LLR value and the second LLR value to obtain the first decoding result and the second decoding result, the processing module 801 is configured to perform SCL decoding based on the first LLR value and the second LLR value to obtain the second decoding result.

For another example, the processing module 801 is configured to determine the first LLR value and the second LLR value, where the first LLR value is determined based on the first symbol sequence corresponding to the code bit sequence, the second LLR value is obtained based on the second symbol sequence, the second symbol sequence is obtained by adding the first disturbance value to the first symbol sequence, and the first symbol sequence is different from the second symbol sequence. The processing module 801 is further configured to perform decoding based on the first LLR value and the second LLR value to obtain the decoding result.

In a possible implementation, the first disturbance value is a disturbance value generated online; or the first disturbance value is a Gaussian distribution noise value; or the first disturbance value is a preset disturbance value; or the first disturbance value is determined based on a signal-to-noise ratio and/or power of the first symbol sequence.

In a possible implementation, when performing decoding based on the first LLR value and the second LLR value to obtain the decoding result, the processing module 801 is configured to perform SCL decoding based on the first LLR value and the second LLR value to obtain the decoding result.

In a possible implementation, when the terminal device is a chip, the transceiver module 802 may be a communication interface, a pin, a circuit, or the like. The communication interface may be configured to input to-be-processed data to a processor, and may output a processing result of the processor to the outside. During specific implementation, the communication interface may be a general purpose input/output (general purpose input/output, GPIO) interface, and may be connected to a plurality of peripheral devices (for example, a display (LCD), a camera (camera), a radio frequency (radio frequency, RF) module, and an antenna). The communication interface is connected to the processor through a bus.

The processing module 801 may be a processor. The processor may execute computer-executable instructions stored in a storage module, so that the chip performs the method in any one of embodiments in FIG. 3 to FIG. 6.

Further, the processor may include a controller, an arithmetic logic unit, and a register. For example, the controller is mainly responsible for instruction decoding, and sending a control signal for an operation corresponding to the instructions. The arithmetic logic unit is mainly responsible for performing a fixed-point or floating-point arithmetic operation, a shift operation, a logic operation, and the like, and may also perform an address operation and address translation. The register is mainly responsible for saving register operands, intermediate operation results, and the like that are temporarily stored during instruction execution. During specific implementation, a hardware architecture of the processor may be an ASIC architecture, a microprocessor without interlocked piped stages (microprocessor without interlocked piped stages, MIPS) architecture, an advanced reduced instruction set computer machine (advanced RISC machine, ARM) architecture, a second processor (network processor, NP) architecture, or the like. The processor may be a single-core or multi-core processor.

The storage module may be a storage module, for example, a register or a cache, inside the chip. Alternatively, the storage module may be a storage module, for example, a ROM or another type of static storage device that can store static information and instructions, or a RAM, located outside the chip.

It should be noted that a function corresponding to each of the processor and the interface may be implemented by using a hardware design, a software design, or a combination of software and hardware. This is not limited herein.

FIG. 9 is a diagram of a simplified structure of a terminal device according to an embodiment of this application. For ease of understanding and illustration, an example in which the terminal device is a mobile phone is used in FIG. 9. As shown in FIG. 9, the terminal device includes at least one processor, and may further include a radio frequency circuit, an antenna, and an input/output apparatus. The processor may be configured to process a communication protocol and communication data, and may be further configured to control the terminal device, execute a software program, process data of the software program, and the like. The terminal device may further include a memory. The memory is mainly configured to store a software program and data. These related programs may be loaded into the memory when the communication apparatus is delivered from a factory, or may be loaded into the memory when needed later. The radio frequency circuit is mainly configured to: perform conversion between a baseband signal and a radio frequency signal, and process the radio frequency signal. The antenna is mainly configured to receive/send a radio frequency signal in an electromagnetic wave form, and the antenna is the antenna provided in embodiments of this application. The input/output apparatus, such as a touchscreen, a display, or a keyboard, is mainly configured to: receive data input by a user and output data to the user. It should be noted that some types of terminal devices may have no input/output apparatus.

When needing to send data, after performing baseband processing on the to-be-sent data, the processor outputs a baseband signal to the radio frequency circuit; and the radio frequency circuit performs radio frequency processing on the baseband signal and then sends the radio frequency signal to the outside in a form of an electromagnetic wave through the antenna. When data is sent to the terminal device, the radio frequency circuit receives the radio frequency signal through the antenna, converts the radio frequency signal into a baseband signal, and outputs the baseband signal to the processor. The processor converts the baseband signal into data, and processes the data. For ease of description, FIG. 9 shows only one memory and one processor. An actual terminal device product may include one or more processors and one or more memories. The memory may also be referred to as a storage medium, a storage device, or the like. The memory may be disposed independent of the processor, or may be integrated with the processor. This is not limited in embodiments of this application.

In this embodiment of this application, an antenna having sending and receiving functions and the radio frequency circuit may be considered as a receiving unit and a sending unit (which may also be collectively referred to as a transceiver unit) of the terminal device, and a processor having a processing function may be considered as a processing unit of the terminal device. As shown in FIG. 9, the terminal device includes a receiving module 31, a processing module 32, and a sending module 33. The receiving module 31 may also be referred to as a receiver, a receiving machine, a receiver circuit, or the like. The sending module 33 may also be referred to as a sender, a transmitter, a transmitter machine, a transmitter circuit, or the like. The processing module 32 may also be referred to as a processor, a processing board, a processing apparatus, or the like.

For example, the processing module 32 is configured to perform a function of the terminal device in any one of embodiments shown in FIG. 3 to FIG. 6.

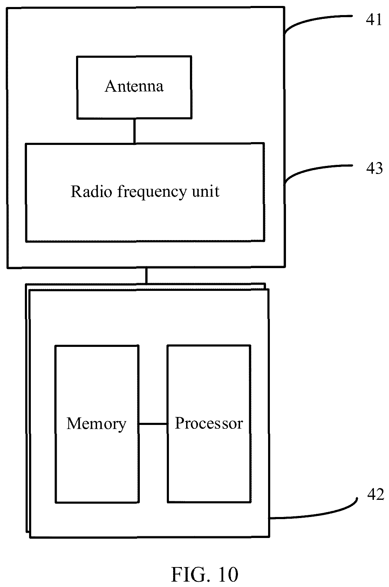

FIG. 10 is a diagram of a simplified structure of a network device according to an embodiment of this application. The network device includes a baseband part 42 and a part for radio frequency signal sending/receiving and conversion. The part for radio frequency signal sending/receiving and conversion further includes a receiving module 41 and a sending module 43 (which may also be collectively referred to as a transceiver module). The part for radio frequency signal sending/receiving and conversion is mainly configured to: send/receive a radio frequency signal and perform conversion between a radio frequency signal and a baseband signal. The baseband part 42 is mainly configured to: perform baseband processing, control the network device, and the like. The receiving module 41 may also be referred to as a receiver, a receiving machine, a receiver circuit, or the like. The sending module 43 may also be referred to as a sender, a transmitter, a transmitter machine, a transmitter circuit, or the like. The baseband part 42 is usually a control center of the network device, may also be referred to as a processing module, and is configured to perform the steps performed by the network device in any one of embodiments shown in FIG. 3 to FIG. 6. For details, refer to the foregoing descriptions of the related parts.

The baseband part 42 may include one or more boards. Each board may include one or more processors and one or more memories. The processor is configured to read and execute a program in the memory, to implement a baseband processing function and control the network device. If there are a plurality of boards, the boards may be interconnected to increase a processing capability. In an optional implementation, the plurality of boards may share one or more processors, or the plurality of boards share one or more memories, or the plurality of boards share one or more processors at the same time.

For example, the sending module 43 is configured to perform a function of the network device in any one of embodiments shown in FIG. 3 to FIG. 6.

An embodiment of this application further provides a communication apparatus. The communication apparatus includes at least one processor and a memory. The memory is configured to store a computer program or instructions. The at least one processor is configured to execute the computer program or the instructions in the memory, so that the method in any one of embodiments shown in FIG. 3 to FIG. 6 is performed.

An embodiment of this application further provides a computer-readable storage medium. The computer-readable storage medium stores computer instructions. When the computer instructions are executed, a computer is enabled to perform the method according to any one of embodiments shown in FIG. 3 to FIG. 6.

An embodiment of this application further provides a computer program product. The computer program product includes computer program code. When the computer program code is run by a computer, the computer is enabled to perform the method according to any one of embodiments shown in FIG. 3 to FIG. 6.

An embodiment of this application provides a chip. The chip is coupled to a memory, and is configured to read and execute program instructions in the memory, so that an apparatus in which the chip is located implements the method in any possible implementation of any one of embodiments shown in FIG. 3 to FIG. 6.

In embodiments of this application, unless otherwise specified, "/" represents an "or" relationship between associated objects. For example, A/B may represent A or B. In this application, "and/or" describes only an association relationship between associated objects and represents that three relationships may exist. For example, A and/or B may represent the following three cases: Only A exists, both A and B exist, and only B exists, where A and B may be singular or plural. In addition, in the descriptions of this application, unless otherwise specified, "plurality of" means two or more. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural. In addition, to clearly describe the technical solutions in embodiments of this application, terms such as first and second are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference.

Reference to "an embodiment", "some embodiments", or the like described in embodiments of this application means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and variants thereof all mean "include but are not limited to", unless otherwise specifically emphasized in another manner.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

In embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

When the computer instructions are loaded and executed on the computer, all or some of the procedures or functions according to embodiments of this application may be implemented. The computer may be a general-purpose computer, a dedicated computer, a computer network, or another programmable apparatus. The computer instructions may be stored in a computer-readable storage medium, or may be transmitted by using a computer-readable storage medium. The computer-readable storage medium may be any usable medium accessible by a computer, or a data storage device, for example, a server or a data center, integrating one or more usable media. The usable medium may be a magnetic medium (for example, a floppy disk, a hard disk drive, or a magnetic tape), an optical medium (for example, a DVD), a semiconductor medium (for example, a solid-state disk (solid-state disk, SSD)), or the like.

The steps in the method embodiments of this application may be reordered, combined, or deleted based on an actual need.

The modules in the apparatus embodiments of this application may be combined, divided, or deleted based on an actual need.

## Claims

1. A decoding method, comprising:

    determining a first log-likelihood ratio LLR value;
    determining a second LLR value based on the first LLR value and a first disturbance value, wherein the first LLR value is different from the second LLR value; and
    performing decoding based on the second LLR value to obtain a second decoding result.

2. The method according to claim 1, wherein determining the first LLR value comprises:

    obtaining a symbol sequence, wherein the symbol sequence corresponds to a code bit sequence;
    demodulating the symbol sequence to obtain a third LLR value; and
    determining the first LLR value based on the third LLR value.

3. The method according to claim 2, wherein the first LLR value comprises the third LLR value.

4. The method according to claim 2, wherein determining the first LLR value based on the third LLR value comprises: determining an LLR value of an information bit and/or an LLR value of a frozen bit based on the third LLR value, wherein the first LLR value comprises the LLR value of the information bit and/or the LLR value of the frozen bit.

5. The method according to claim 4, wherein the information bit is a bit whose reliability is higher than or equal to preset reliability.

6. The method according to claim 2, wherein determining the first LLR value based on the third LLR value comprises: determining, based on the third LLR value, an LLR value of an intermediate layer node corresponding to an information bit whose reliability is higher than or equal to preset reliability, wherein the first LLR value comprises the LLR value of the intermediate layer node.

7. The method according to any one of claims 1 to 6, wherein the method further comprises:

   performing decoding based on the third LLR value to obtain a first decoding result; and determining the second LLR value based on the first LLR value and the first disturbance value comprises:
   when the first decoding result is incorrect, determining the second LLR value based on the first LLR value and the first disturbance value.

8. The method according to any one of claims 1 to 7, wherein

   the first disturbance value is a disturbance value generated online; or
   the first disturbance value is a Gaussian distribution noise value; or
   the first disturbance value is a preset disturbance value; or
   the first disturbance value is determined based on a signal-to-noise ratio and/or power of the symbol sequence.

9. The method according to claim 1, wherein performing decoding based on the second LLR value to obtain the second decoding result comprises: performing successive cancellation list SCL decoding based on the second LLR value to obtain the second decoding result.

10. A decoding method, comprising:

    obtaining a first symbol sequence, wherein the first symbol sequence corresponds to a code bit sequence;
    adding a first disturbance value to the first symbol sequence, wherein the first disturbance value is for generating a second symbol sequence, and the first symbol sequence is different from the second symbol sequence;
demodulating the second symbol sequence to obtain a second log-likelihood ratio LLR value; and
performing decoding based on the second LLR value to obtain a second decoding result.

11. The method according to claim 10, wherein the method further comprises:

    demodulating the first symbol sequence to obtain a first LLR value; and
    performing decoding based on the first LLR value to obtain a first decoding result; and
    adding the first disturbance value to the first symbol sequence comprises:
    when the first decoding result is incorrect, adding the first disturbance value to the first symbol sequence.

12. The method according to claim 10 or 11, wherein

    the first disturbance value is a disturbance value generated online; or
    the first disturbance value is a Gaussian distribution noise value; or
    the first disturbance value is a preset disturbance value; or
    the first disturbance value is determined based on a signal-to-noise ratio and/or power of the first symbol sequence.

13. The method according to claim 10, wherein performing decoding based on the second LLR value to obtain the second decoding result comprises:
    performing successive cancellation list SCL decoding based on the second LLR value to obtain the second decoding result.

14. A decoding method, comprising:

    determining a first log-likelihood ratio LLR value and a second LLR value, wherein the first LLR value is determined based on a third LLR value, the third LLR value is determined based on a symbol sequence, the symbol sequence corresponds to a code bit sequence, the second LLR value is determined based on the first LLR value and a first disturbance value, and the first LLR value is different from the second LLR value; and
    performing decoding based on the first LLR value and the second LLR value to obtain a decoding result.

15. The method according to claim 14, wherein the first LLR value comprises the third LLR value.

16. The method according to claim 14, wherein that the first LLR value is determined based on the third LLR value comprises:

the first LLR value comprises an LLR value of an information bit and/or an LLR value of a frozen bit, and the LLR value of the information bit and/or the LLR value of the frozen bit are/is determined based on the third LLR value.

17. The method according to claim 14, wherein that the first LLR value is determined based on the third LLR value comprises:

the first LLR value comprises an LLR value of an intermediate layer node corresponding to an information bit whose reliability is higher than or equal to preset reliability, and the LLR value of the intermediate layer node is determined based on the third LLR value.

18. The method according to any one of claims 14 to 17, wherein

the first disturbance value is a disturbance value generated online; or
the first disturbance value is a Gaussian distribution noise value; or
the first disturbance value is a preset disturbance value; or
the first disturbance value is determined based on a signal-to-noise ratio and/or power of the symbol sequence.

19. A communication apparatus, comprising a unit or a module configured to implement the method according to any one of claims 1 to 18.

20. A communication apparatus, comprising a processor, wherein the processor invokes a computer program stored in a memory, to perform the method according to any one of claims 1 to 18.

21. A computer-readable storage medium, wherein the computer-readable storage medium stores a computer program, and when the computer program is run, the method according to any one of claims 1 to 18 is performed.

22. A chip, wherein the chip comprises at least one processor and an interface, the processor is configured to read and execute instructions stored in a memory, and when the instructions are run, the method according to any one of claims 1 to 18 is performed.

23. A computer program product comprising instructions, wherein when the computer program product runs on a computer, the method according to any one of claims 1 to 18 is performed.

FIG. 1a

FIG. 1b

FIG. 1c

Sort based on path metric PM values

Path width L

FIG. 1d

Level s=0    s=1    s=2    s=3    s=4

Bit
sequence
number

i=0
i=1
i=2
i=3
i=4
i=5
i=6
i=7
i=8
i=9
i=10
i=11
i=12
i=13
i=14
i=15

Left side
(information side)

Right side (log-likelihood
ratio LLR input side)

FIG. 1e

FIG. 2

| |
|---|
| Determine a first log-likelihood ratio LLR value |

301

| |
|---|
| Determine a second LLR value based on the first LLR value and a first disturbance value, where the first LLR value is different from the second LLR value |

302

| |
|---|
| Perform decoding based on the second LLR value to obtain a second decoding result |

303

FIG. 3

| |
|---|
| Obtain a first symbol sequence |

401

| |
|---|
| Add a first disturbance value to the first symbol sequence, where the first disturbance value is for generating a second symbol sequence, and the first symbol sequence is different from the second symbol sequence |

402

| |
|---|
| Demodulate the second symbol sequence to obtain a second log-likelihood ratio LLR value |

403

| |
|---|
| Perform decoding based on the second LLR value to obtain a second decoding result |

404

FIG. 4

Determine a first log-likelihood ratio LLR value and a second LLR value, where the first LLR value is determined based on a third LLR value, the third LLR value is determined based on a symbol sequence, the symbol sequence corresponds to a code bit sequence, the second LLR value is determined based on the first LLR value and a first disturbance value, and the first LLR value is different from the second LLR value

501

Perform decoding based on the first LLR value and the second LLR value to obtain a decoding result

502

FIG. 5

Determine a first log-likelihood ratio LLR value and a second LLR value, where the first LLR value is determined based on a first symbol sequence corresponding to a code bit sequence, the second LLR value is obtained based on a second symbol sequence, the second symbol sequence is obtained by adding a first disturbance value to the first symbol sequence, and the first symbol sequence is different from the second symbol sequence

601

Perform decoding based on the first LLR value and the second LLR value to obtain a decoding result

602

FIG. 6

FIG. 7

Communication apparatus 800

Processing module 801

Transceiver module 802

Storage module 803

FIG. 8

Antenna

Radio frequency circuit

Memory

Processor

Input/Output apparatus

31
33
32

FIG. 9

Antenna

Radio frequency unit

Memory

Processor

FIG. 10

## INTERNATIONAL SEARCH REPORT

| International application No. |
| --- |
| **PCT/CN2023/090080** |

### A. CLASSIFICATION OF SUBJECT MATTER

H03M13/09(2006.01)i; H04L1/00(2006.01)i

According to International Patent Classification (IPC) or to both national classification and IPC

### B. FIELDS SEARCHED

Minimum documentation searched (classification system followed by classification symbols)

IPC:H04L,H03M

Documentation searched other than minimum documentation to the extent that such documents are included in the fields searched

Electronic data base consulted during the international search (name of data base and, where practicable, search terms used)

CNABS: CNTXT; VEN; DWPI; ENTXT; ENTXTC; 3GPP: 对数似然比, 扰动, 加扰, 第一, 第二, 第三, 译码, 比特, 序列, 符号, 冻结比特, 固定比特, 信息比特, 可靠度, 噪声, 信噪比, 功率, LLR, scramble, scrambling, first, second, third, decoding, bit, sequence, symbol, frozen bit, information bit, reliability, noize, SNR, power

### C. DOCUMENTS CONSIDERED TO BE RELEVANT

| Category* | Citation of document, with indication, where appropriate, of the relevant passages | Relevant to claim No. |
| --- | --- | --- |
| X | CN 112583419 A (HUAWEI TECHNOLOGIES CO., LTD.) 30 March 2021 (2021-03-30) claims 1-25 | 1, 7-10, 12-14, 17-23 |
| Y | CN 111917419 A (HUAWEI TECHNOLOGIES CO., LTD.) 10 November 2020 (2020-11-10) claims 1-25 | 2-6, 11, 15, 16 |
| Y | CN 109428607 A (HUAWEI TECHNOLOGIES CO., LTD.) 05 March 2019 (2019-03-05) claims 1-27 | 2-6, 11, 15, 16 |
| A | CN 111917419 A (HUAWEI TECHNOLOGIES CO., LTD.) 10 November 2020 (2020-11-10) entire document | 1-23 |
| A | US 2014108748 A1 (SAMSUNG ELECTRONICS CO., LTD. et al.) 17 April 2014 (2014-04-17) entire document | 1-23 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 November 2023** | **20 November 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/090080**

| Patent document cited in search report | | | Publication date (day/month/year) | Patent family member(s) | | | Publication date (day/month/year) |
|---|---|---|---|---|---|---|---|
| CN | 112583419 | A | 30 March 2021 | None | | | |
| CN | 111917419 | A | 10 November 2020 | None | | | |
| CN | 109428607 | A | 05 March 2019 | WO | 2019042271 | A1 | 07 March 2019 |
| US | 2014108748 | A1 | 17 April 2014 | US | 9239778 | B2 | 19 January 2016 |
| | | | | EP | 2722993 | A1 | 23 April 2014 |
| | | | | EP | 2722993 | B1 | 10 June 2015 |
| | | | | KR | 20140050152 | A | 29 April 2014 |
| | | | | KR | 102015121 | B1 | 28 August 2019 |

Form PCT/ISA/210 (patent family annex) (July 2022)